# EUROPÄISCHE PATENTSCHRIFT

(11) **EP 0 660 982 B1**
(45) Veröffentlichungstag und Bekanntmachung des Hinweises auf die Patenterteilung: **27.01.1999**
(21) Anmeldenummer: 93920697.5
(22) Anmeldetag: 09.09.1993
(51) Int. Cl.: H03K 17/732, H03M 1/06

(54) **ANSTEUERSCHALTUNG FÜR EINEN ABSCHALTBAREN THYRISTOR**
DRIVING CIRCUIT FOR A GATE TURN-OFF THYRISTOR
CIRCUIT DE COMMANDE POUR UN THYRISTOR INTERRUPTIBLE

(30) Priorität: 21.09.1992 EP 92116099
(43) Veröffentlichungstag der Anmeldung: 05.07.1995
(73) Patentinhaber: SIEMENS AKTIENGESELLSCHAFT, 80333 München (DE)
(72) Erfinder: BAUDELOT, Eric, D-91085 Weisendorf (DE); KRATZ, Gerhard, D-91336 Heroldsbach (DE)
(86) Internationale Anmeldenummer: EP9302444
(87) Internationale Veröffentlichungsnummer: WO9407309

(56) Entgegenhaltungen:
- DE-A- 3 709 150
- US-A- 5 077 487

## Beschreibung

Die Erfindung bezieht sich auf eine Ansteuerschaltung für einen abschaltbaren Thyristor, bestehend aus einem Einschaltkreis und einem Ausschaltkreis, wobei der Einschaltkreis eine Spannungsquelle mit paralleler Speicherkapazität und paralleler Reihenschaltung eines Schalters und einer Rückspeisediode und eine Stromquelle aufweist, wobei als Stromquelle eine Induktivität vorgesehen ist, deren Anschlüsse einerseits mittels eines Schalters und einer Freilaufdiode mit einem positiven Pol der Spannungsquelle des Einschaltkreises und andererseits mit einem Anschluß des Steuerkreises und mittels eines Schalters mit einem negativen Pol der Spannungsquelle des Einschaltkreises des abschaltbaren Thyristors verbunden sind und wobei der Steueranschluß des abschaltbaren Thyristors mittels des Schalters und mittels der Rückspeisediode mit den Polen der Spannungsquelle des Einschaltkreises verbunden ist.

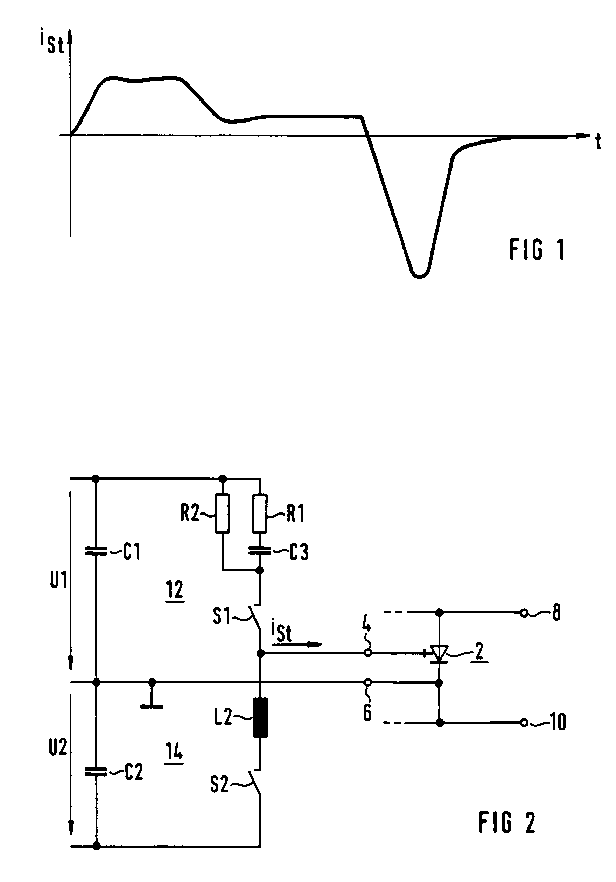

Eine derartige Ansteuerschaltung, auch Steuerschaltung bzw. Steuergenerator genannt, ist aus der DE 37 09 150 C2 bekannt. Für abschaltbare Thyristoren, auch Gate-Turn-Off(GTO)-Thyristoren genannt, ist ein besonderer Steuerstromverlauf erwünscht, der aus Figur 1 ersichtlich ist. Eine bekannte Schaltung, mit der diese Realisierung möglich ist, zeigt Figur 2.

Ein Steuergenerator eines GTO-Thyristors besteht aus zwei Spannungsquellen: Eine zum Einschalten, die andere zum Abschalten. Die Funktion "Einschalten" hat zwei Aufgaben "Zünden" und "in Betrieb halten", die Funktion "Abschalten" hat die Aufgabe "Abschalten" und "Bereitstellen der negativen Gatespannung während der Sperrphase".

Bekannte Steuerschaltungen haben den Nachteil, daß die zur Steuerung des abschaltbaren Leistungshalbleiters aufgewendete Energie verloren ist. Ein weiterer Nachteil ist, daß der zeitliche Verlauf des Steuerstromes nur durch Austausch von Bauelementen beeinflußbar ist. Dabei weicht die reale Kurvenform des Steuerstromes jedoch in jedem Fall relativ stark von der idealen Kurvenform ab. Dies betrifft insbesondere die Flankenanstiege in der Ein- und Abschaltphase sowie die Hohe des negativen abschaltbaren Spitzenstromes.

Mit der gattungsgemäßen Ansteuerschaltung soll eine nahezu vollständige Rückgewinnung der Steuerenergie möglich sein. Bei dieser Ansteuerschaltung erhalten zunächst die Einschaltstromquelle und die Ausschaltstromquelle ihre Energie von einer Spannungsquelle, wenn sie im Ladekreis geschaltet sind. Diese Steuerenergie speichern sie dann, indem sie den Steuerstrom im Freilaufkreis verlustfrei zirkulieren lassen. Zur Steuerung des abschaltbaren Thyristors wird dessen Steuerstrecke dann in den Freilaufkreis geschaltet. Die Steuerenergie wird während und nach der Steuerphase (Einschalten bzw. Ausschalten) durch Rückladen wiedergewonnen. In diesem Fall ist die betreffende Stromquelle dem Rückladekreis mit der Spannungsquelle und der Speicherkapazität verbunden. Letztere nimmt die Energie wieder auf.

Diese gattungsgemäße Ansteuerschaltung für einen abschaltbaren Thyristor weist folgende Nachteile auf:
- Ein sicherer Sperrzustand des abschaltbaren Thyristors ist nicht gewährleistet.
- Eine du/dt-Festigkeit des abschaltbaren Thyristors ist nicht gewährleistet.
- Ein sicherer Abschaltvorgang ist nur durch den Aufbau eines Abschaltstromes möglich, der großer sein muß als der maximale vom Hersteller angegebene Abschaltstrom I_{GRM}, wodurch in Schalter und Diode des Abschaltkreises unnötige Durchlaßverluste verursacht werden und die Wechselstrombelastung der Speicherkapazität sich erhöht.
- Beim Rückladevorgang kann eine Überspannung an der Speicherkapazität entstehen.
- Die Dimensionierung der Induktivität der Einschaltstromquelle ist sehr kritisch.

Der Erfindung liegt nun die Aufgabe zugrunde, eine Ansteuerschaltung für einen abschaltbaren Thyristor anzugeben, die die aufgeführten Nachteile nicht mehr aufweist.

Diese Aufgabe wird erfindungsgemäß dadurch gelost, daß eine zweite Induktivität als zweite Stromquelle vorgesehen ist, deren erster Anschluß mit dem Schalter des Einschaltkreises und deren zweiter Anschluß einerseits mittels einer Freilaufdiode und andererseits mittels eines Schalters mit den Polen der Spannungsquelle des Einschaltkreises verknüpft ist und daß der Ausschaltkreis eine Spannungsquelle mit paralleler Speicherkapazität und mit serieller Reihenschaltung eines Schalters und einer Induktivität aufweist, wobei der Ausschaltkreis mit den Anschlüssen des Steuerkreises des abschaltbaren Thyristors verknüpft ist und mittels einer Entkopplungsdiode vom Einschaltkreis entkoppelt ist.

Die Aufgabe wird ebenfalls erfindungsgemäß dadurch gelost, daß eine zweite Induktivität als zweite Stromquelle vorgesehen ist, die elektrisch in Reihe zur ersten Induktivität derart geschaltet ist, daß ein Verbindungsanschluß der beiden Induktivitäten einerseits mit der Freilaufiode und andererseits mit dem Schalter des Einschaltkreises verknüpft ist und wobei ein zweiter Anschluß der zweiten Induktivität einerseits mittels einer Freilaufdiode und andererseits mittels eines Schalters mit den Polen der Spannungsquelle des Einschaltkreises verbunden ist, und daß der Ausschaltkreis eine Spannungsquelle mit paralleler Speicherkapazität und mit serieller Reihenschaltung eines Schalters und einer Induktivität aufweist, wobei der Ausschaltkreis mit den Anschlüssen des Steuerkreises des abschaltbaren Thyristors verbunden ist und mittels einer Entkopplunsdiode vom Einschaltkreis entkoppelt ist.

Dadurch, daß als Stromquelle zwei Induktivitäten vorgesehen sind, die entweder in Bezug auf die Spannungsquelle des Einschaltkreises parallel geschaltet oder elektrisch in Reihe geschaltet sind, besteht die Möglichkeit jede Induktivität für eine Aufgabe zu dimensionieren. Die erste Induktivität ist für die Erzeugung des Einschaltstromes und die zweite Induktivität für die Erzeugung des Haltestromes verantwortlich. Durch die Aufteilung der Stromquelle in zwei Stromquellen besteht keine Schwierigkeit bei der Dimensionierung der Induktivitäten.

Da die Ansteuerschaltung einen Abschaltkreis mit einer eigenen Spannungsquelle mit paralleler Speicherkapazität, einem Schalter und einer Induktivität aufweist, wird ein sicherer Sperrzustand, eine du/dt-Festigkeit und ein sicheres Abschalten erreicht.

Ebenfalls wird die Aufgabe erfindungsgemäß dadurch gelost, daß als Induktivität eine sättigbare Drossel vorgesehen ist, und daß der Ausschaltkreis eine Spannungsquelle mit paralleler Speicherkapazität und mit serieller Reihenschaltung eines Schalters und einer Induktivität aufweist, wobei der Ausschaltkreis mit den Anschlüssen des Steuerkreises des abschaltbaren Thyristors verknüpft ist und mittels einer Entkopplungsdiode vom Einschaltkreis entkoppelt ist.

Bei diesem Lösungsvorschlag ist anstelle von zwei Induktivitäten nur eine sättigbare Drossel vorgesehen. Diese Drossel vereinigt jedoch zwei Induktivitäten, die in Abhängigkeit des durchfließenden Stromes sich einstellen. D.h., die Funktion zweier körperlich vorhandener Induktivitäten wird bei diesem Lösungsvorschlag durch eine sättigbare Drossel erfüllt. Dadurch wird ein Schalter und eine Freilaufdiode eingespart.

Mittels dieser Ansteuerschaltungen für einen abschaltbaren Thyristor besteht die Möglichkeit den Einschaltstrom und den Haltestrom des abschaltbaren Thyristors in Abhängigkeit von Strom-Sollwerten zu regeln. Bei der ersten Ausführungsform der Ansteuerschaltung wird eine getrennte Stromregelung verwendet, wogegen bei der zweiten und dritten Ausführungsform der Ansteuerschaltung nur eine Stromregelung mit kommutierbarem Strom-Sollwert benutzt werden.Ein weiterer Vorteil dieser Ausführungsformen der Ansteuerschaltung besteht darin, daß die Entstehung einer Überspannung an der Speicherkapazität der Spannungsquelle des Einschaltkreises verhindert wird. Dazu wird der Spannungs-Istwert der Spannung an der Speicherkapazität mit einem einstellbaren Grenzwert derart überwacht, daß bei Überschreitung die Stromquellen in Freilauf ohne Stromregelung und ohne Stromreduzierung geschaltet werden.

Weitere vorteilhafte Ausführungsformen sind den Unteransprüchen zu entnehmen.

Zur weiteren Erläuterung der erfindungsgemäßen Ansteuerschaltung für einen abschaltbaren Thyristor wird auf die Zeichnung Bezug genommen, in der mehrere Ausführungsbeispiele schematisch veranschaulicht sind.
- Figur 1: zeigt einen Verlauf des Steuerstromes für einen abschaltbaren Thyristor in einem Diagramm über der Zeit t,
- Figur 2: veranschaulicht eine bekannte Ansteuerschaltung, in
- Figur 3: ist eine erste Ausführungsform der erfindungsgemäßen Ansteuerschaltung dargestellt,
- Figur 4: stellt eine weitere Ausführungsform der erfindungsgemäßen Ansteuerschaltung dar, in
- Figur 5: ist eine dritten Ausführungsform der erfindungsgemäßen Ansteuerschaltung dargestellt,
- Figur 6: zeigte eine vorteilhafte Ausführungsform der Ansteuerschaltung nach Figur 3,
- Figur 7: zeigt eine vorteilhafte Ausführungsform der Ansteuerschaltung nach Figur 4, in den
- Figuren 8 bis 15: sind verschiedene Schaltstufen der Ansteuerschaltung nach Figur 3 dargestellt, die
- Figuren 16 und 21: zeigen jeweils in einem Diagramm über der Zeit t den Verlauf des Einschaltstromes, in den
- Figuren 17 und 22: sind jeweils in einem Diagramm über der Zeit t der Verlauf des Haltestromes, und in den
- Figuren 18 und 23: sind jeweils der zugehörige Verlauf des Gatestromes in einem Diagramm über der Zeit t dargestellt, die
- Figuren 19 und 20: zeigen weitere Schaltstufen der Ansteuerschaltung nach Figur 3, die
- Figuren 24 bis 30: zeigen verschiedene Schaltstufen der Ansteuerschaltung nach Figur 4, wobei in den
- Figuren 31 bis 33: die zugehörigen Stromverläufe jeweils in einem Diagramm über der Zeit t dargestellt sind, in den
- Figuren 34 und 35: sind weitere Schaltstufen der Ausführungsform nach Figur 4 dargestellt, die
- Figuren 36 bis 41: veranschaulichen verschiedene Schaltstufen der Ansteuerschaltung nach Figur 5 und in den
- Figuren 42 und 43: sind die Verläufe der zugehörigen Ströme jeweils in einem Diagramm über der Zeit t dargestellt.

Figur 1 zeigt den Verlauf des Steuerstromes ist für einen abschaltbaren Leistungshalbleiter 2 in Abhängigkeit von der Zeit t. Zum Einschalten dieses abschaltbaren Leistungshalbleiters 2, insbesondere eines GTO-Thyristors 2, ist eine Einschaltstromüberhöhung notwendig. Um den Einschaltvorgang möglichst schnell zu machen, ist ferner eine steile Anstiegsflanke der Einschaltstromüberhöhung erwünscht. Wenn der GTO-Thyristor 2 eingeschaltet hat, kann dieser Zustand mit einem verminderten Haltestrom aufrechterhalten werden. Zum Abschalten des abschaltbaren Thyristors 2 ist ein bestimmter negativer Abschaltstrom erforderlich. Auch hier ist wiederum eine steile Abschaltflanke erwünscht, um den Abschaltvorgang möglichst schnell zu machen.

Die in Figur 2 gezeigte bekannte Schaltung, mit welcher der Steuerstromverlauf gemäß Figur 1 erreichbar ist, enthält als abschaltbaren Leistungshalbleiter 2 einen Gate-Turn-Off(GTO)-Thyristor. Dabei sind mit 4 und 6 die Anschlüsse für den Steuerkreis des abschaltbaren Leistungshalbleiters 2 bezeichnet, während mit 8 und 10 die Anschlüsse für den Lastkreis des Halbleiters 2 bezeichnet sind. Die bekannte Steuerschaltung gemäß Figur 2 weist einen Einschaltkreis 12 und einen Ausschaltkreis 14 für den GTO-Thyristor 2 auf. Der Einschaltkreis 12 wird von einer Spannungsquelle U1, einer dieser parallel geschalteten Kapazität C1, einem Schalter S1, einer Reihenschaltung aus einem Widerstand R1 und einem Kondensator C3 sowie einem zu der letztgenannten Reihenschaltung parallel liegenden Widerstand R2 gebildet. Der Ausschaltkreis 14 besteht aus einer Spannungsquelle U2, einer dieser parallel geschalteten Kapazität C2, einem Schalter S2 und einer Induktivität L2. Für das Einleiten der Einschaltphase wird der Schalter S1 geschlossen, während der Schalter S2 offen bleibt. Die Einschaltstromüberhöhung bildet sich aufgrund der RC-Kombination der Elemente R1,C3 und R2. Die Ausschaltphase wird durch Öffnen des Schalters S1 und durch Schließen des Schalters S2 eingeleitet. Die Induktivität L2, die parasitär oder gewünscht diskret sein kann, soll den Stromanstieg beim Abschalten begrenzen.

Wesentlicher Nachteil der Steuerschaltung nach Figur 2 ist, daß in den Elementen R1 und R2 während des Einschaltens Steuerenergie in Wärme umgesetzt wird und damit verlorengeht. Beim Ausschalten wird Steuerenergie in der Gate-Kathoden-Strecke des abschaltbaren Leistungshalbleiters 2 in Wärme umgesetzt und ist damit verloren. Eine Rückgewinnung von Steuerenergie ist nicht vorgesehen und auch nicht möglich.

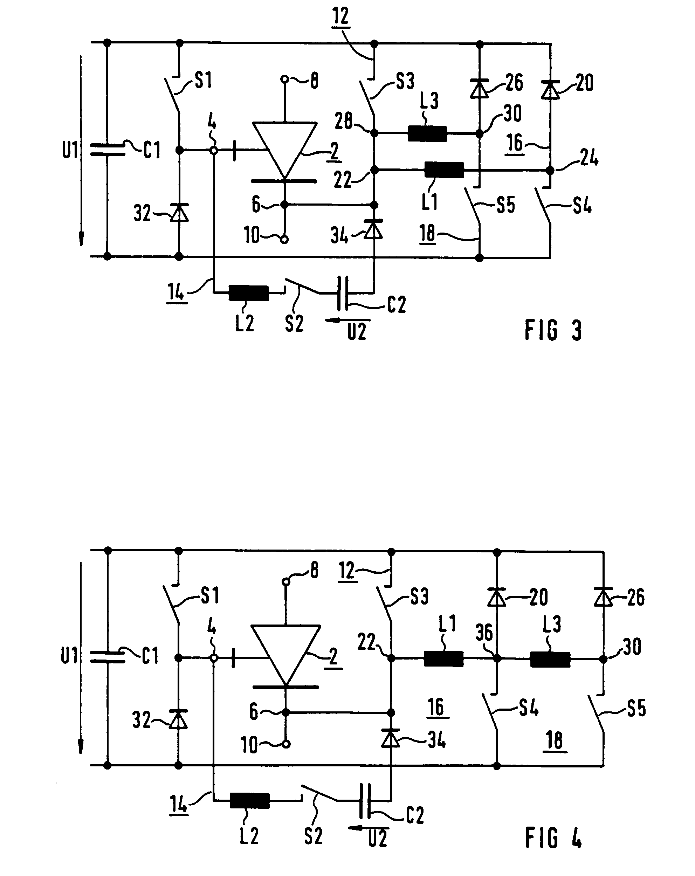

In Figur 3 ist eine erste Ausführungsform der erfindungsgemäßen Ansteuerschaltung gezeigt. Diese Ansteuerschaltung weist einen Ausschaltkreis 14 gemäß der Ansteuerschaltung nach Figur 2 auf. Der Einschaltkreis 12 besteht aus der Spannungsquelle U1, einer dieser parallel geschalteten Speicherkapazität C1, einem Schalter S1 und zwei Einschaltstromquellen 16 und 18. Die Einschaltstromquelle 16 besteht aus zwei Schaltern S3 und S4, einer Induktivität L1 und einer Freilaufdiode 20. Der Schalter S3 verbindet einen positiven Pol der Spannungsquelle U1 mit einem ersten Anschluß 22 der Induktivität L1, wobei deren zweiter Anschluß 24 über den Schalter S4 mit einem negativen Pol der Spannungsquelle U1 verbindbar ist. Der Anschluß 22 ist ebenfalls mit dem Anschluß 6 des abschaltbaren Thyistors 2 und der Anschluß 24 ist außerdem mittels der Freilaufdiode 20 mit dem positiven Pol der Spannungsquelle U1 verknüpft. Die zweite Einschaltstromquelle 18 besteht aus zwei Schaltern S3 und S5, einer Induktivität L3 und einer Freilaufdiode 26. Dabei verbindet der Schalter S3 außerdem den positiven Pol der Spannungsquelle U1 mit einem Anschluß 28 der Induktivität L3, deren zweiter Anschluß 30 mittels des Schalters S5 mit dem negativen Pol der Spannungsquelle U1 verbindbar ist. Der erste Anschluß 28 der Induktivität L3 ist ebenfalls mit dem Steueranschluß 6 des GTO-Thyristors 2 elektrisch leitend verbunden. Der Steueranschluß 4 des GTO-Thyristors 2, der mittels des Schalters S1 mit dem positiven Pol der Spannungsquelle U1 verbindbar ist, ist mittels einer Rückspeisediode 32 mit dem negativen Pol der Spannungsquelle U1 verknüpft. Der Ausschaltkreis 14 gemäß Figur 2 ist mit dem negativen Pol der Spannungsquelle U2 mittels der Reihenschaltung, bestehend aus dem Schalter S2 und der Induktivität L2, mit dem ersten Steueranschluß 4 des GTO-Thyristors 2 verknüpft, wogegen der positive Pol der Spannungsquelle U2 mittels einer Entkopplungsdiode 34 mit dem zweiten Steueranschluß 6 des GTO-Thyristors 2 verknüpft ist.

Die Figur 4 zeigt eine zweite Ausführungsform der erfindungsgemäßen Ansteuerschaltung für einen abschaltbaren Thyristor 2. Diese zweite Ausführungsform unterscheidet sich von der ersten Ausführungsform nach Figur 3 dadurch, daß die zwei Stromquellen 16 und 18 bzw. deren Induktivitäten L1 und L3 elektrisch in Reihe geschaltet sind. D.h., der zweite Anschluß 24 der Induktivität L1 und der erste Anschluß 28 der Induktivität L3 sind in einem Verbindungsanschluß 36 vereint.

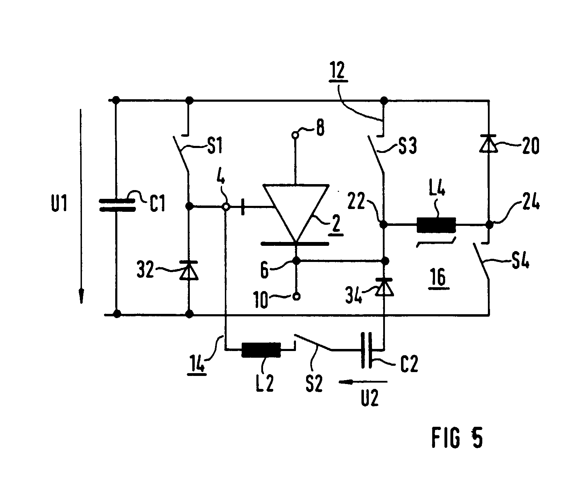

In Figur 5 ist eine dritte Ausführungsform der erfindungsgemäßen Ansteuerschaltung für den abschaltbaren Thyristor 2 dargestellt. Diese dritte Ansteuerschaltung unterscheidet sich von der ersten Ansteuerschaltung nach Figur 3 dadurch, daß nur eine Stromquelle 16 vorgesehen ist, die anstelle der Induktivität L1 eine sättigbare Drossel L4 aufweist.

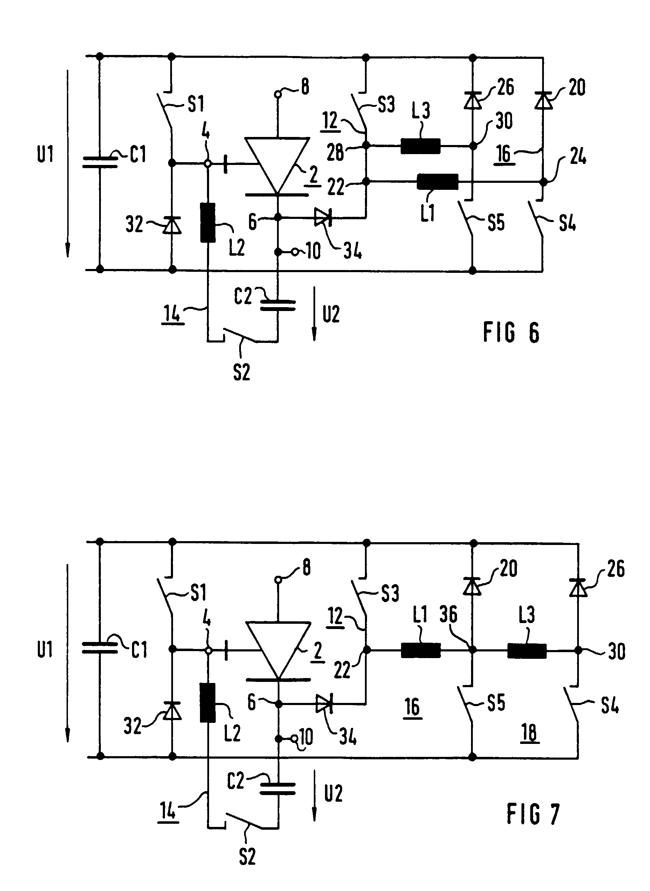

Die Figuren 6 bzw. 7 zeigen vorteilhafte Ausführungsform der Ansteuerschaltung nach Figur 3 bzw. 4, wobei der positive Pol des Ausschaltkreises 14 mit einem zweiten Steueranschluß 6 des abschaltbaren Thyristors 2 verknüpft ist und der erste Anschluß 22 und 28 der Induktivitäten L1 und L3 bzw. der erste Anschluß 22 der Induktivität L1 mittels der Entkopplungsdiode 34 mit dem zweiten Steueranschluß 6 des abschaltbaren Thyristors 2 verbunden ist. Dadurch wird die Entkopplungsdiode 34 nicht mehr vom hohen Ausschaltstrom durchflossen, so daß man eine preiswertere Diode 34 verwenden kann. Außerdem geht dadurch weniger Steuerenergie verloren.

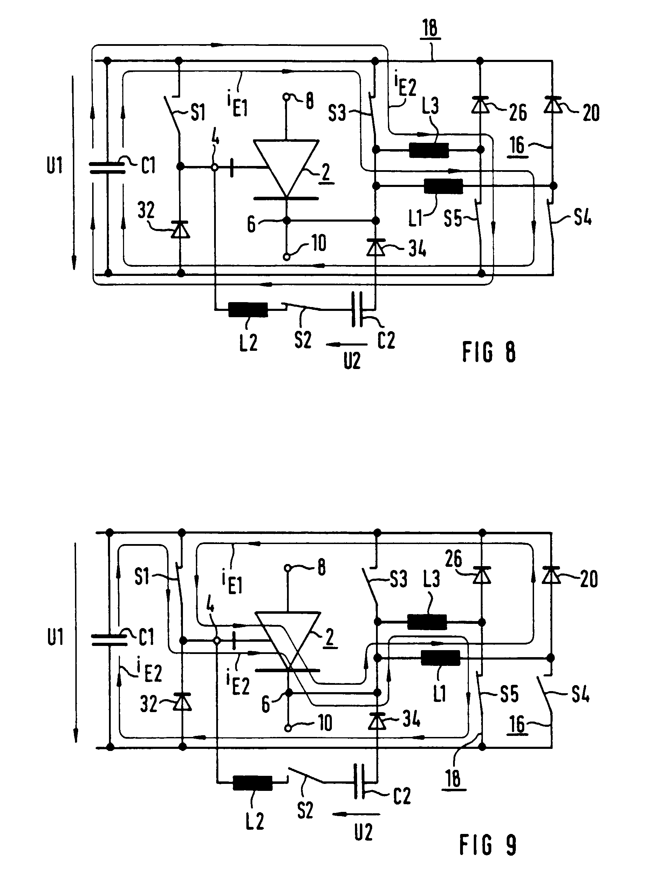

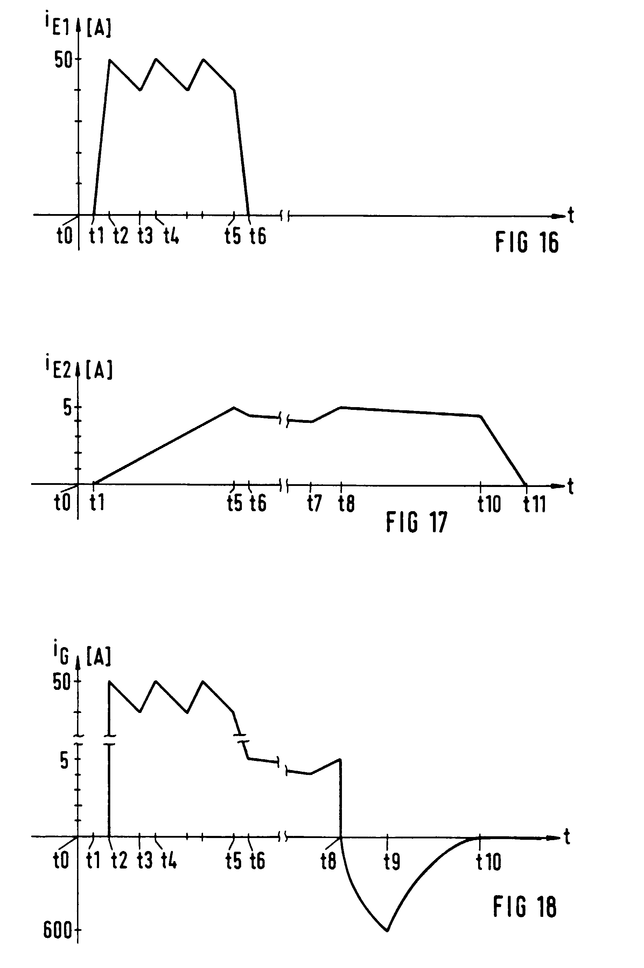

Nunmehr soll die Ansteuerschaltung nach Figur 3 anhand der Figuren 8 bis 15 phasenweise erläutert werden, wobei die in den Figuren 16 bis 18 dargestellten Schaltstufen im zeitlichen Verlauf des Steuerstromes erreicht werden.

In der Zeitspanne t1-t0 sind alle Schalter S1 bis S5 offen, d.h., der GTO-Thyristor 2 ist ausgeschaltet bzw. nichts betriebsbereit. Der Einschaltstrom i_{E1}, der Haltestrom i_{E2} und der Ausschaltstrom sind Null.

Figur 8 zeigt die Ansteuerschaltung zu einem Zeitpunkt t, der zwischen den Zeitpunkten t1 und t2 liegt. Hier sind die Schalter S3, S4 und S5 eingeschaltet, während der Schalter S1 offen ist. Der GTO-Thyristor 2 ist noch ausgeschaltet. Die Induktivitäten L1 und L3 werden durch einen Einschaltstrom i_{E1} und einen Haltestrom i_{E2} geladen. Die Ladekreise sind jeweils durch einen mit Pfeilspitzen versehenen Stromverlauf gekennzeichnet. Diese Ladekreise enthalten die Spannungsquelle U1, die dazu parallel geschaltete Speicherkapazität C1, den Schalter S3, die Induktivität L1 bzw. L3 und den Schalter S4 bzw. S5. Durch die unterschiedlichen Werte der beiden Induktivitäten L1 und L3, wobei der Wert der Induktivität L3 sehr viel größer ist als der Wert der Induktivität L1, ist der Stromanstieg des Einschaltstromes i_{E1} (Figur 16) sehr viel steiler als der Stromanstieg des Haltestromes i_{E2} (Figur 17). Zum Zeitpunkt t2 hat bereits der Einschaltstrom i_{E1} seine maximale Amplitude von beispielsweise 50 A erreicht. Zu diesem Zeitpunkt t2 werden die Schalter S3, S4 und S2 geöffnet und der Schalter S1 geschlossen (Figur 9). Die zuvor geladene Induktivität L1 treibt den Einschaltstrom i_{E1} durch einen Freilaufkreis, der die Induktivität L1, die Freilaufdiode 20, den Schalter S1 und die Steuerstrecke (Gate-Kathode-Strecke) des GTO-Thyristors 2 enthält. Der GTO-Thyristor 2 wird dadurch eingeschaltet (Figur 18).

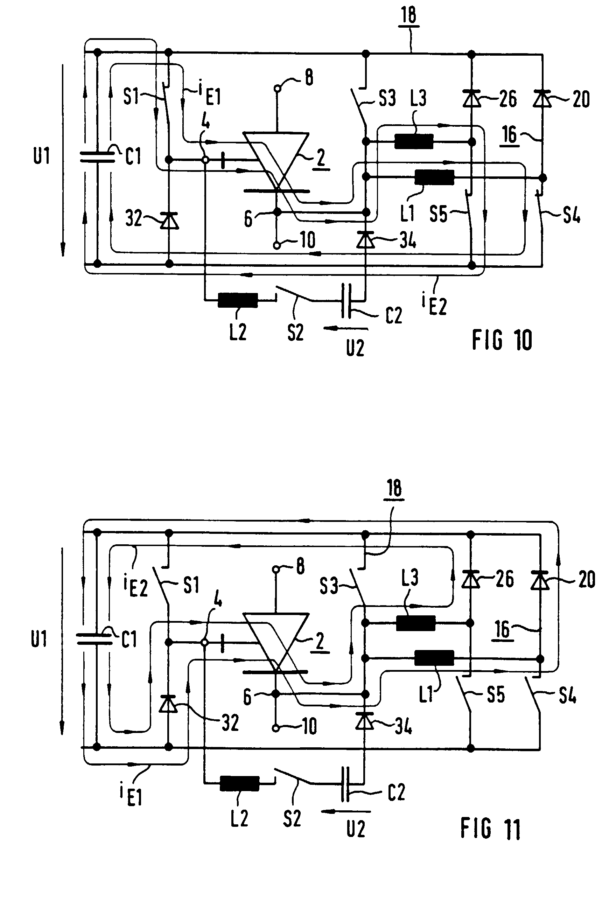

Die Figur 10 zeigt die Schalterstellung zum Zeitpunkt t3 gemäß Figur 16. Zu diesem Zeitpunkt t3 ist der Einschaltstrom i_{E1} auf seinen minimalsten Wert abgesunken, zu dem der Einschaltvorgang noch aufrechterhalten werden kann. Damit der Einschaltstrom i_{E1} nicht weiter absinkt, wird er aus der Speicherkapazität C1 wieder erhöht. Dadurch wird der Schalter S4 wieder geschlossen und der Einschaltstrom i_{E1} kommutiert von der Freilaufdiode 20 zum Schalter S4. Dadurch wird die Induktivität L1 nachgeladen. Zum Zeitpunkt t4 ist dieser Nachladevorgang bereits beendet, da der Einschaltstrom i_{E1} seine maximale Amplitude wieder erreicht hat. Diese Stromregelung wiederholt sich so oft, bis die Einschaltzeit des abschaltbaren Thyristors 2 abgelaufen ist und dieser Thyristor 2 eingeschaltet ist, d.h. der Thyristor 2 kann mittels eines Haltestroms i_{E2}, deren Amplitudenwert sehr viel kleiner ist als der Amplitudenwert des Einschaltstromes i_{E1}, im eingeschalteten Zustand gehalten werden. Zum Zeitpunkt t5 ist dieser Betriebszustand erreicht.

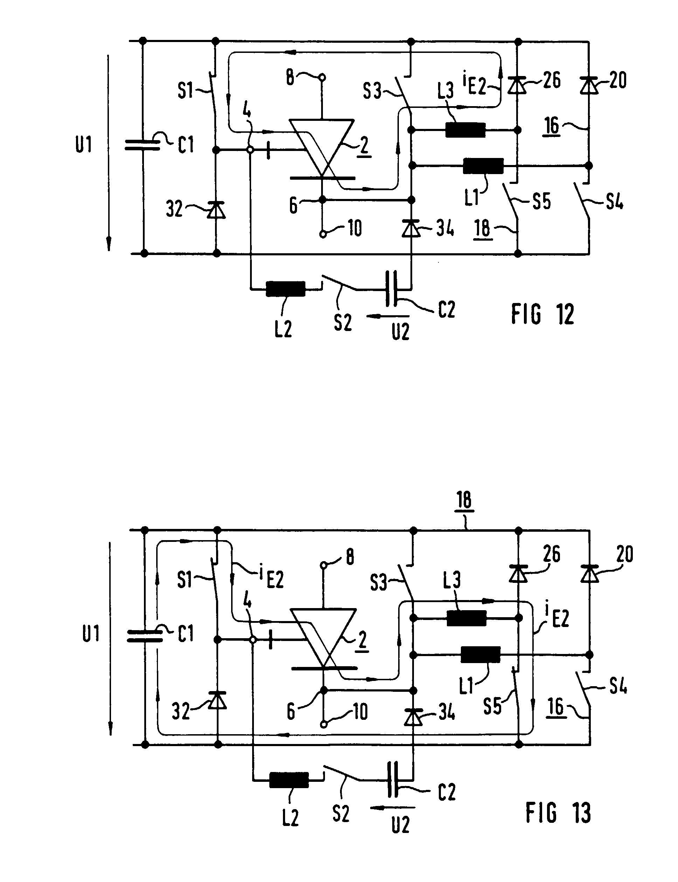

Wird zum Zeitpunkt t5 festgestellt, daß die Spannung an der Speicherkapazität C1 unterhalb eines oberen Grenzwertes ist, werden die Schalter S4 und S1 geöffnet, so daß die Energie der Induktivität L1 in die Speicherkapazität C1 rückgespeist werden kann. Da außerdem der Haltestrom i_{E2} seine maximale Amplitude, beispielsweise 5 A, erreicht hat, wird ebenfalls der Schalter S5 geöffnet, so daß auch die Induktivität L3 eine geringe Energie in die Speicherkapazität C1 rückspeist. Diese Schalterstellungen und die Stromverläufe i_{E1} und i_{E2} sind in der Figur 11 dargestellt. In der Figur 16 ist die Energierückspeisung von der Induktivität L1 in die Speicherkapazität C1 durch die steile Flanke beim Ausschaltvorgang des Einschaltstromes i_{E1} ersichtlich.
Zum Zeitpunkt t6 ist der Einschaltstrom i_{E1} auf Null abgesunken und der GTO-Thyristor 2 wird mittels des Haltestroms i_{E2} im eingeschalteten Zustand gehalten. Dazu sind gemäß der Figur 12 die Schalter S2, S3, S4 und S5 offen und der Schalter S1 geschlossen. Somit ist die Steuerstrecke (Gate-Kathoden-Strecke) des GTO-Thyristors 2 in einem Freilaufkreis, bestehend aus der Induktivität L3, der Freilaufdiode 26 und dem Schalter S1 geschaltet.

Zum Zeitpunkt t7 hat der Haltestrom i_{E2} gemäß Figur 17 seine minimalste Amplitude erreicht, mit dem der Betriebszustand des GTO-Thyristors 2 aufrechterhalten werden kann. Damit der Haltestrom i_{E2} nicht weiter absinkt, wird gemäß Figur 13 die Induktivität L3 wieder nachgeladen. Dazu wird der Schalter S5 wieder geschlossen. Zum Zeitpunkt t8 nach Figur 17 hat der Haltestrom i_{E2} wieder seine maximale Amplitude erreicht. Diese Stromregelung wird solange fortgesetzt, bis von einer übergeordneten Steuer- und Regeleinrichtung ein Aus-Befehl kommt.

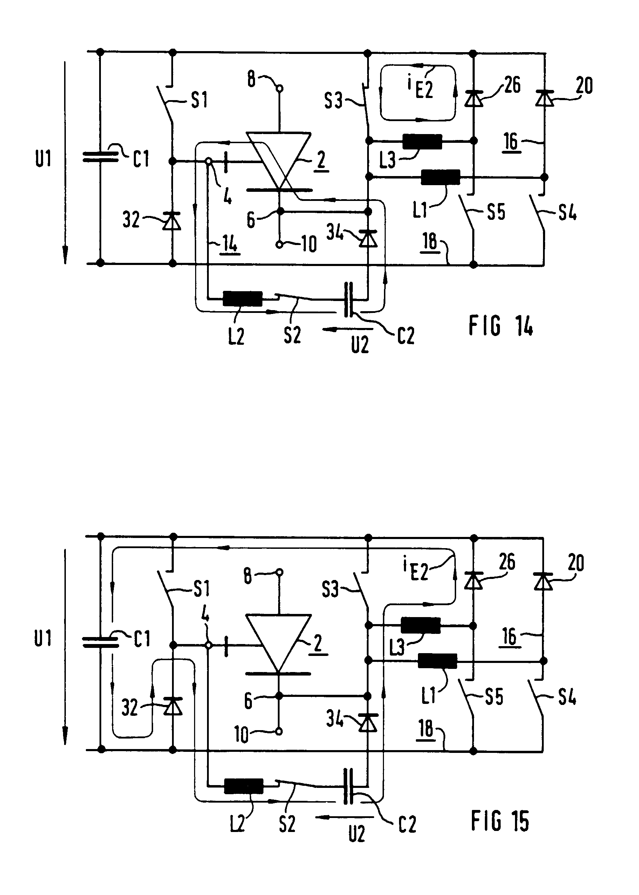

Zum Zeitpunkt t8 trifft ein Aus-Befehl infolge eines Aus-Befehls für den GTO-Thyristor in einer nicht näher dargestellten Steuerschaltung für die Schalter S1 bis S5 ein, wodurch die Schalter S1 und S5 wieder geöffnet und die Schalter S2 und S3 geschlossen werden (Figur 14). Dadurch fließt der Haltestrom i_{E2} in einen Freilaufkreis, bestehend aus der Freilaufdiode 26, dem Schalter S3 und der Induktivität L3, und der Ausschaltkreis 14 ist in die Steuerstrekke des GTO-Thyristors 2 geschaltet. Mittels der Spannungsquelle U2 mit paralleler Speicherkapazität C2 und der Induktivität L2 wird ein Ausschaltstrom gegen die Strecke (Gate-Kathode-Strecke) des GTO-Thyristors 2 getrieben. Der maximale Ausschaltstrom beträgt beispielsweise 600 A, der zum Zeitpunkt t9 erreicht ist. Zum Zeitpunkt t9 sperrt der GTO-Thyristor 2. Dieser Zustand wird dadurch aufrechtehalten, daß der Ausschaltkreis 14, solange der GTO-Thyristor 2 gesperrt sein soll, an der Steuerstrecke des GTO-Thyristors 2 geschaltet bleibt.

Die Figur 15 zeigt eine weitere Schaltstufe, wobei die Schalter S1, S3, S4 und S5 offen und der Schalter S2 geschlossen sind. Dadurch wird einerseits die Energie der Induktivität L3 in die Speicherkpazität C1 rückgespeist und andererseits der Sperrzustand des GTO-Thyristors 2 aufrechterhalten. Zum Zeitpunkt tll ist der Rückladevorgang beendet.

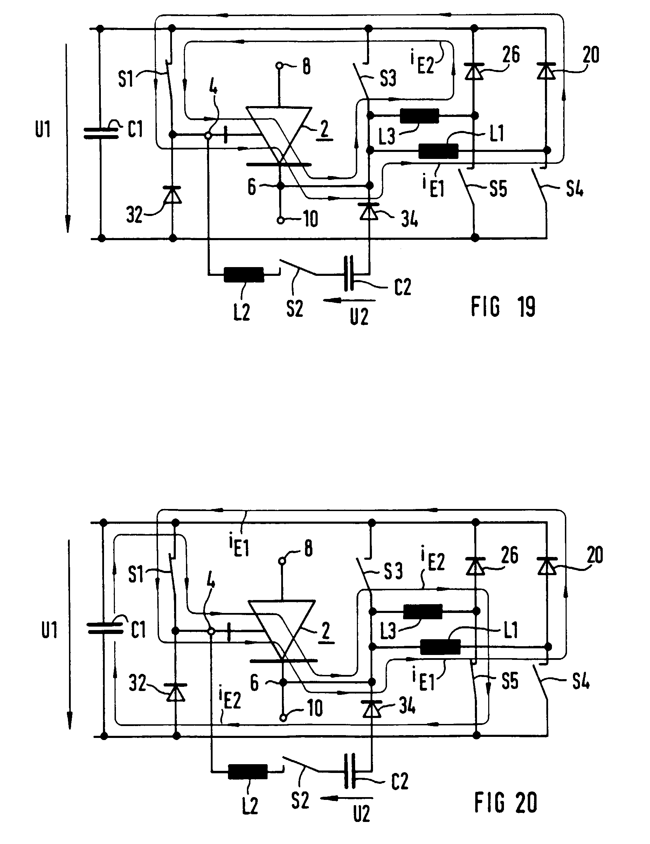

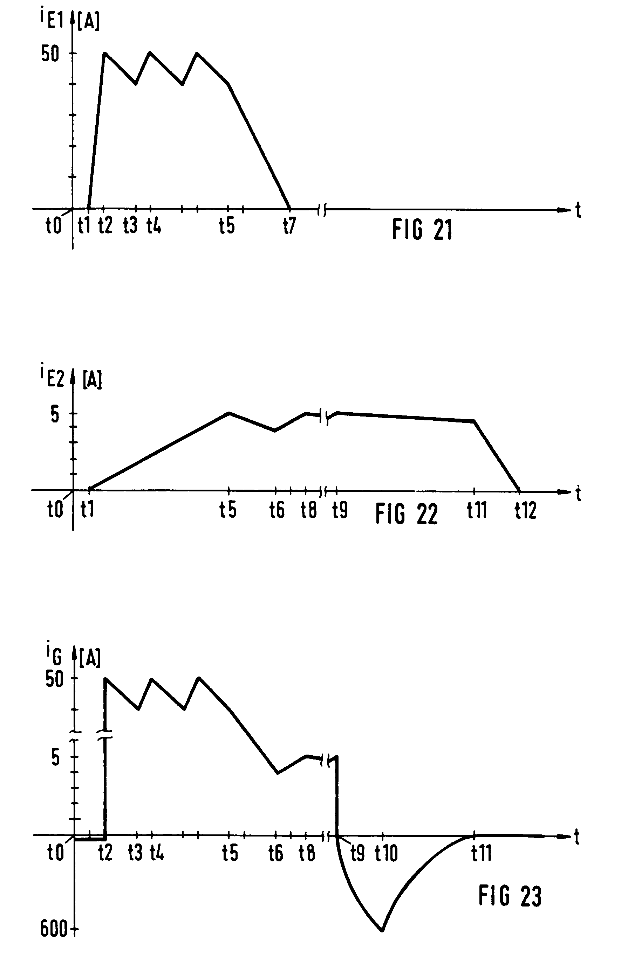

Die Figuren 19 und 20 zeigen weitere Schaltstufen der Ansteuerschaltung für einen abschaltbaren Thyristor 2 und die Figuren 21 bis 23 zeigen die zugehörigen Stromverläufe des Einschaltstromes i_{E1}, des Haltestromes i_{E2} und des Gatestromes i_{G}. Bei dieser Steuervariante wird berücksichtigt, daß die Spannung an der Speicherkapazität C1 bereits einen oberen Grenzwert überschritten hat. Dadurch ist eine Energierückspeisung wegen Entstehung einer Überspannung an der Speicherkapazität C1 zu unterbinden. Im Gegensatz zur Figur 11 (Rückspeisung) ist in der Figur 19 der Schalter S1 geschlossen und die anderen Schalter S2 bis S5, wie Figur 11 zeigt, geöffnet. Dadurch entstehen zwei Freilauf zweige, wodurch der eine Freilaufzweig aus der Induktivität L1, der Freilaufdiode 20, dem Schalter S1 und der Gate-Kathoden-Strecke des GTO-Thyristors 2 und der andere Freilauf zweig aus der Induktivität L3, der Freilaufdiode 26, dem Schalter S1 und der Gate-Kathoden-Strecke des GTO-Thyristors 2 bestehen. Daß diese Freiläufe geschaltet sind, erkennt man an den weniger steilen Flanken beim Ausschaltvorgang des Einschlatstromes i_{E1} gemäß Figur 21 (Zeitspanne T5-t7) und des Haltestromes i_{E2} gemäß Figur 22 (Zeitspanne tll-t12). Der Figur 22 ist außerdem zu entnehmen,daß der Haltestrom i_{E2} bereits zum Zeitpunkt t6 seine minimalste Amplitude erreicht hat, wogegen der Wert des Einschaltstromes i_{E1} immer noch größer ist als der Wert des Haltestromes i_{E2}. Damit der Haltestrom i_{E2} nicht noch mehr abfällt, werden wie in Figur 13 die Schalter S1 und S5 geschlossen und die Schalter S2, S3 und S4 bleiben offen (Figur 20). Dadurch wird die Induktivität L3 nachgeladen. Außerdem kann der Einschaltstrom i_{E1} sich im Freilaufkreis, bestehend aus der Induktivität L1, der Freilaufdiode 20, dem Schalter S1 und der Steuerstrecke des GTO-Thyristors 2, abbauen.

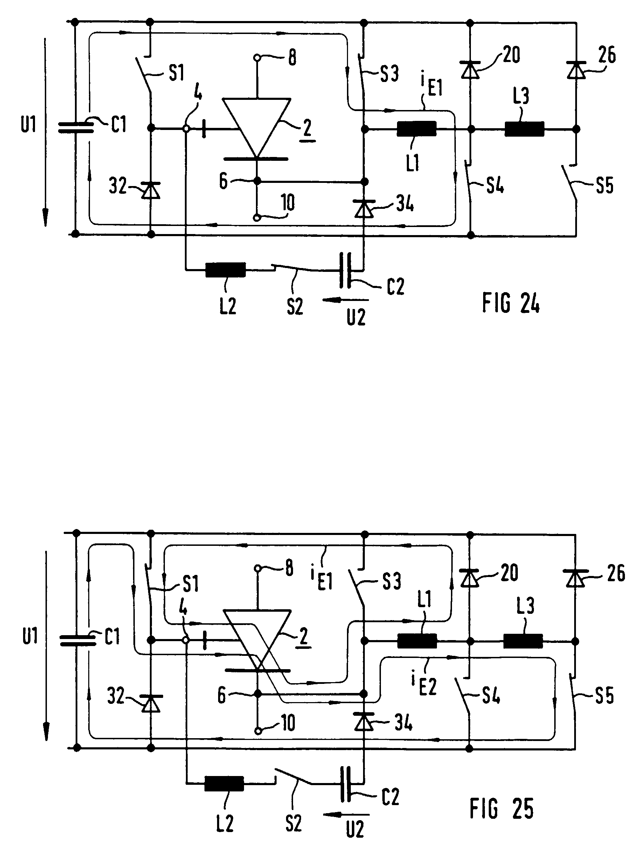

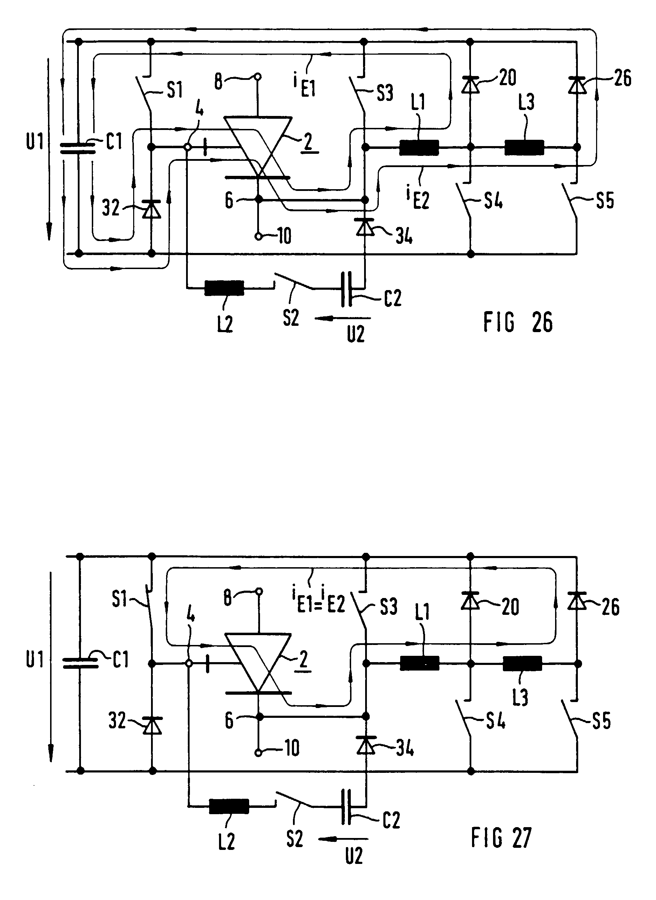

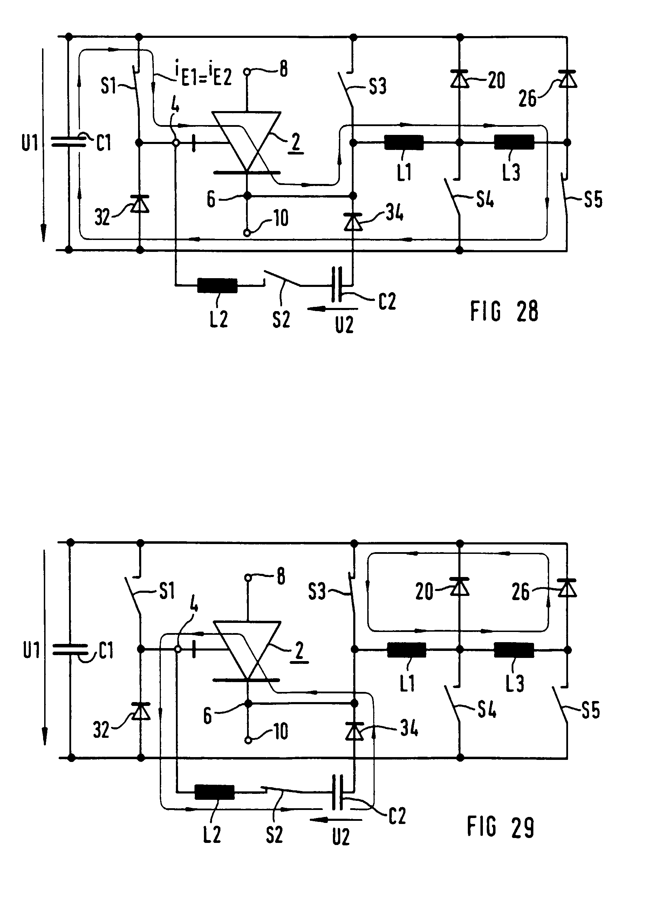

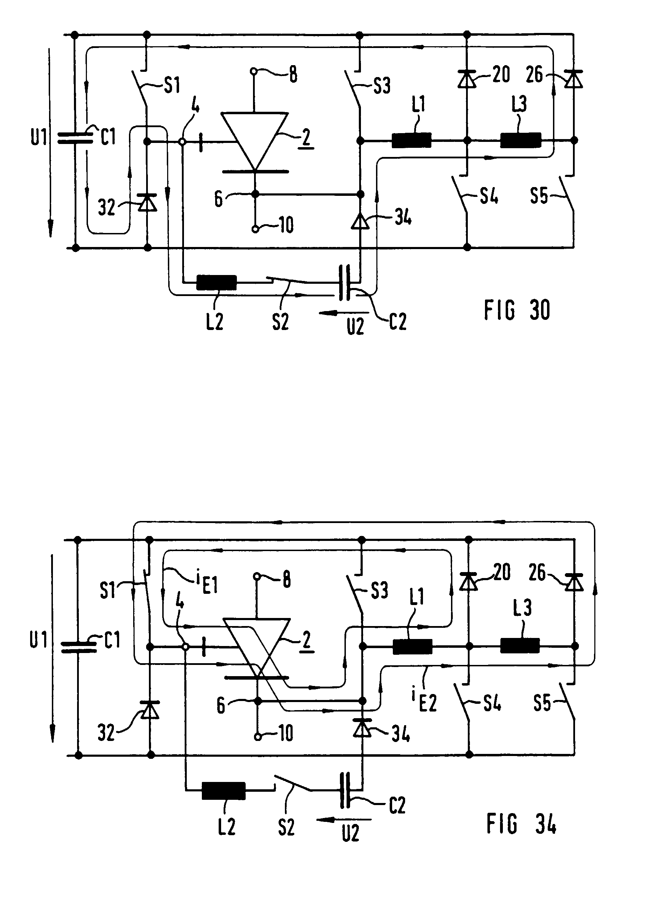

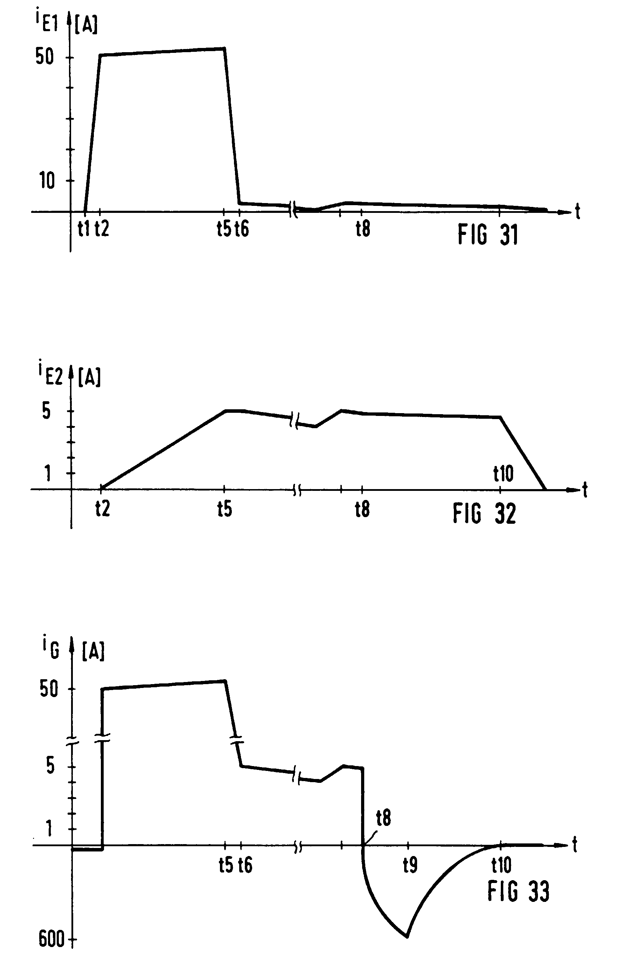

Die Figuren 24 bis 30 und die zugehörigen Stromverläufe gemäß den Figuren 31 bis 33 veranschaulichen phasenweise die Steuerung der Schalter S1 bis S5 der zweiten Ausführungsform der Ansteuerschaltung für einen abschaltbaren Thyristor 2. Gegenüber der Steuerung der ersten Ausführungsform der erfindungsgemäßen Steuerschaltung gibt es bei dieser Steuerung nun eine Stromregelung mit kommutierbarem Sollwert. Auch bei dieser Steuerung der Schalter S1 bis S5 wird die Spannung an der Speicherkapazität C1 verarbeitet. Die Steuerschaltung,die aus Übersichtlichkeitsgründen nicht näher dargestellt ist, hat als Eingangsgrößen einen Schaltbefehl einer übergeordneten Steuer- und Regeleinrichtung, die Istwerte des Einschaltstromes i_{E1}, des Haltestromes i_{E2} und der Spannung an der Speicherkapazität C1 und die zugehörigen Soll- und Grenzwerte. Die Ausgangsgrößen dieser Steuerschaltung sind die Steuerschaltsignale für die Schalter S1 bis S5. In dieser Schaltung ist wenigstens ein Stromregler, wenigstens ein Komparator und eine Logik enthalten. Der Vorteil der zweiten Ausführungsform der Ansteuerschaltung besteht darin, daß die zugehörige Steuerschaltung sich wesentlich vereinfacht, da zur Generierung eines Schaltbefehls ein Freiheitsgrad gespart wird.

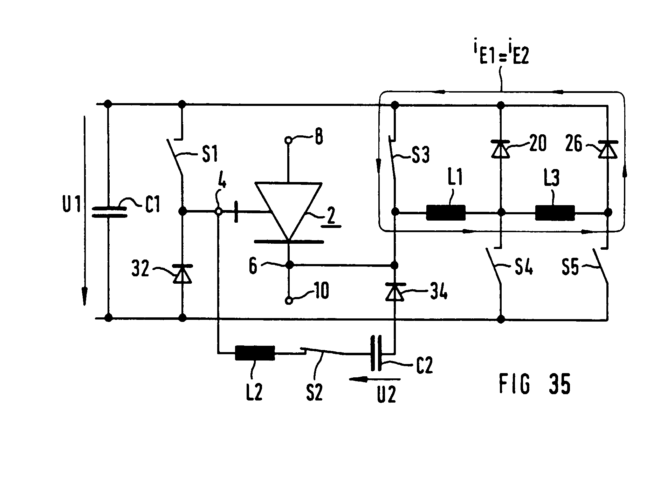

Die Figuren 34 und 35 veranschaulichen Schaltstufen, die geschaltet werden, wenn eine Energierückspeisung aus den Induktivität L1 und L3 in die Speicherkapazität C1 aufgrund einer zu hohen Spannung an der Speicherkapazität C1 nicht ratsam ist, da dadurch eine Überspannung entsteht.

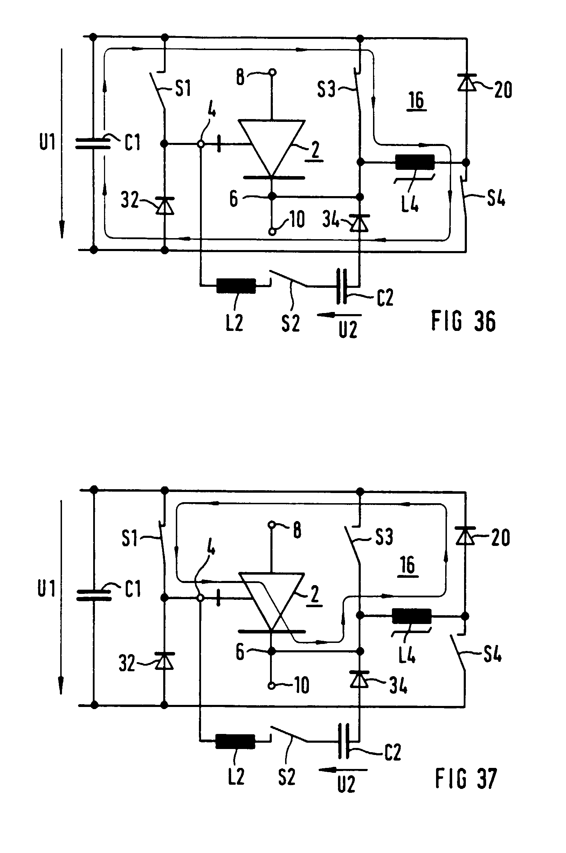

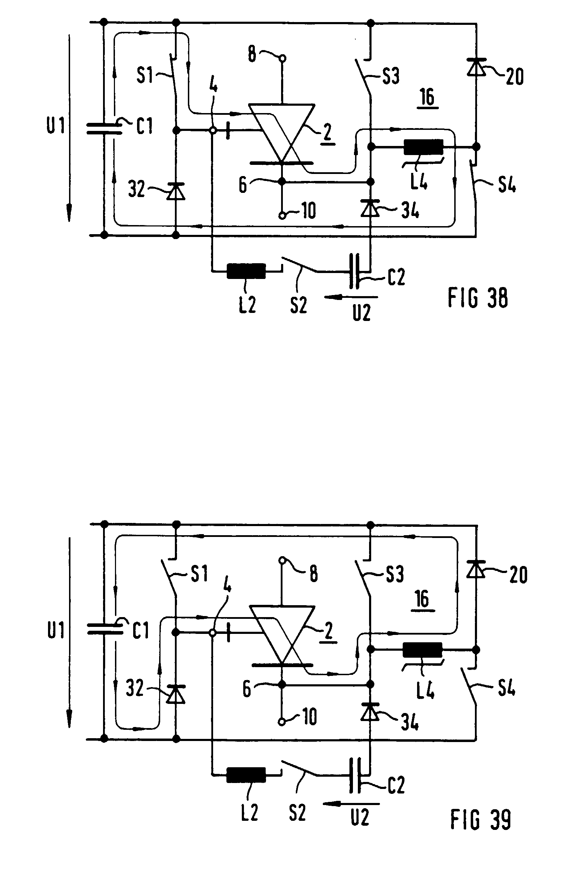

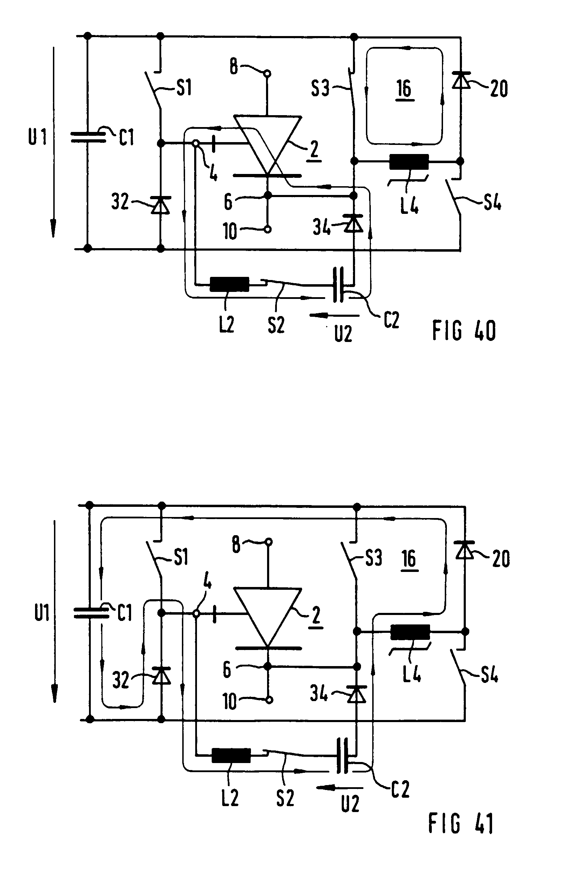

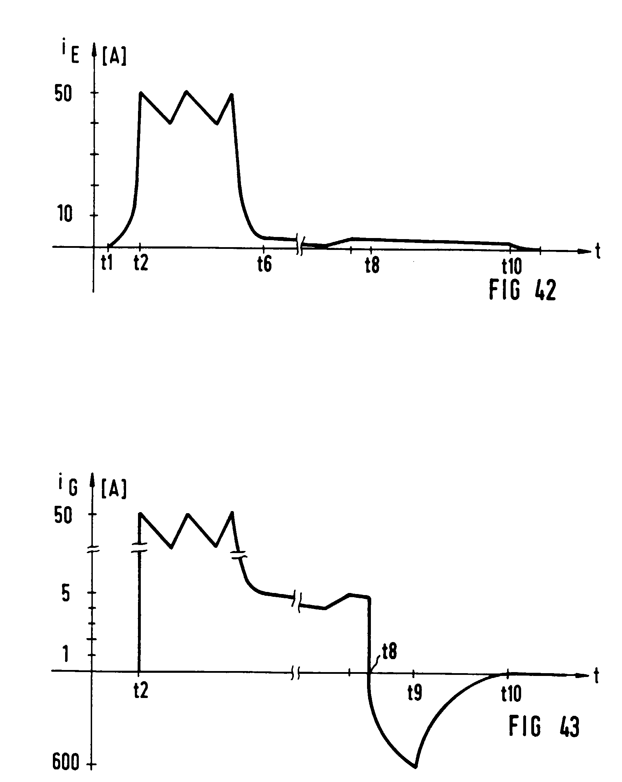

Die Figuren 36 bis 41 und die zugehörigen Stromverläufe gemäß der Figuren 42 und 43 veranschaulichen phasenweise die Steuerung der Schalter S1 bis S4 der dritten Ausführungsform für einen abschaltbaren Thyristor 2. Gegenüber der zweiten Ausführungsform kommt zur Vereinfachung der Steuerschaltung für die Schalter S1 bis S4 noch hinzu, daß die dritte Ausführungsform dieser Ansteuerschaltung sich wesentlich vereinfacht. Diese Vereinfachung zeigt sich in Bauteileeinsparung. Statt der beiden Induktivität L1 und L3, die bei der zweiten Ausführungsform der Ansteuerschaltung eleketrisch in Reihe geschaltet sind, wird hier eine sättigbare Drossel L4 verwendet. Durch diesen Austausch wird auch der Schalter S5 und die zugehörige Freilaufdiode 26 nicht mehr benötigt. Durch die Einsparung des Schalters S5 vereinfacht sich ebenfalls die zugehörige Steuerschaltung.

Die vorstehend beschriebenen Ausführungsformen der erfindungsgemäßen Ansteuerschaltung für einen abschaltbaren Thyristor 2 ist prinzipiell verlustfrei und zwar bis zu höchsten Steuerströmen. Mit anderen Worten, diese Ansteuerschaltungen haben theoretisch keine Verluste an Steuerenergie.

## Patentansprüche

1. Ansteuerschaltung für einen abschaltbaren Thyristor (2), bestehend aus einem Einschaltkreis (12) und einem Ausschaltkreis (14), wobei der Einschaltkreis (12) eine Spannungsquelle (U1) mit paralleler Speicherkapazität (C1) und paralleler Reihenschaltung eines Schalters (S1) und einer Rückspeisediode (32) und eine Stromquelle (16) aufweist, wobei als Stromquelle (16) eine Induktivität (L1) vorgesehen ist, deren Anschlüsse (22,24) einerseits mitteis eines Schalters (S3) und einer Freilaufdiode (20) mit einem positiven Pol der Spannungsquelle (U1) des Einschaltkreises (12) und andererseits mit einem Anschluß (6) des Steuerkreises und mittels eines Schalters (S4) mit einem negativen Pol der Spannungsquelle (Ul) des Einschaltkreises (12) des abschaltbaren Thyristors (2) verbunden sind und wobei der Steueranschluß (4) des abschaltbaren Thyristors (2) mittels des Schalters (S1) und mittels der Rückspeisediode (32) mit den Polen der Spannungsquelle (U1) des Einschaltkreises (12) verbunden ist, **dadurch gekennzeichnet**, daß eine zweite Induktivität (L3) als zweite Stromquelle (18) vorgesehen ist, deren erster Anschluß (28) mit dem Schalter (S3) des Einschaltkreises (12) und deren zweiter Anschluß (30) einerseits mittels einer Freilaufdiode (26) und andererseits mittels eines Schalters (S5) mit den Polen der Spannungsquelle (U1) des Einschaltkreises (12) verknüpft ist und daß der Ausschaltkreis (14) eine Spannungsquelle (U2) mit paralleler Speicherkapazität (C2) und mit serieller Reihenschaltung eines Schalters (S2) und einer Induktivität (L2) aufweist, wobei der Ausschaltkreis (14) mit den Anschlüssen (4,6) des Steuerkreises des abschaltbaren Thyristors (2) verknüpft ist und mittels einer Entkopplungsdiode (34) vom Einschaltkreis (12) entkoppelt ist. (FIG 3)

2. Ansteuerschaltung für einen abschaltbaren Thyristor (2), bestehend aus einem Einschaltkreis (12) und einem Ausschaltkreis (14), wobei der Einschaltkreis (12) eine Spannungsquelle (U1) mit paralleler Speicherkapazität (C1) und paralleler Reihenschaltung eines Schalters (S1) und einer Rückspeisediode (32) und eine Stromquelle (16) aufweist, wobei als Stromquelle (16) eine Induktivität (L1) vorgesehen ist, deren Anschlüsse (22,24) einerseits mittels eines Schalters (S3) und einer Freilaufdiode (20) mit einem positiven Pol der Spannungsquelle (U1) des Einschaltkreises (12) und andererseits mit einem Anschluß (6) des Steuerkreises und mittels eines Schalters (S4) mit einem negativen Pol der Spannungsquelle (U1) des Einschaltkreises (12) des abschaltbaren Thyristors (2) verbunden sind und wobei der Steueranschluß (4) des abschaltbaren Thyristors (2) mittels des Schalters (S1) und mittels der Rückspeisediode (32) mit den Polen der Spannungsquelle (U1) des Einschaltkreises (12) verbunden ist, **dadurch gekennzeichnet**, daß eine zweite Induktivität (L3) als zweite Stromquelle (18) vorgesehen ist, die elektrisch in Reihe zur ersten Induktivität (L1) derart geschaltet ist, daß ein Verbindungsanschluß (36) der beiden Induktivitäten (L1,L3) einerseits mit der Freilaufdiode (20) und andererseits mit dem Schalter (S4) des Einschaltkreises (12) verknüpft ist und wobei ein zweiter Anschluß (30) der zweiten Induktivität (L3) einerseits mittels einer Freilaufdiode (26) und andererseits mittels eines Schalters (S5) mit den Polen der Spannungsquelle (U1) des Einschaltkreises (12) verbunden ist, und daß der Ausschaltkreis (14) eine Spannungsquelle (U2) mit paralleler Speicherkapazität (C2) und mit serieller Reihenschaltung eines Schalters (S2) und einer Induktivität (L2) aufweist, wobei der Ausschaltkreis (14) mit den Anschlüssen (4,6) des Steuerkreises des abschaltbaren Thyristors (2) verbunden ist und mittels einer Entkopplungsdiode (34) vom Einschaltkreis (12) entkoppelt ist. (FIG 4)

3. Ansteuerschaltung für einen abschaltbaren Thyristor (2), bestehend aus einem Einschaltkreis (12) und einem Ausschaltkreis (14), wobei der Einschaltkreis (12) eine Spannungsquelle (U1) mit paralleler Speicherkapazität (C1) und paralleler Reihenschaltung eines Schalters (S1) und einer Rückspeisediode (32) und eine Stromquelle (16) aufweist, wobei als Stromquelle (16) eine Induktivität (L4) vorgesehen ist, deren Anschlüsse (22,24) einerseits mittels eines Schalters (S3) und einer Freilaufdiode (20) mit einem positiven Pol der Spannungsquelle (U1) des Einschaltkreises (12) und andererseits mit einem Anschluß (6) des Steuerkreises und mittels eines Schalters (S4) mit einem negativen Pol der Spannungsquelle (U1) des Einschaltkreises (12) des abschaltbaren Thyristors (2) verbunden sind und wobei der Steueranschluß (4) des abschaltbaren Thyristors (2) mittels des Schalters (S1) und mittels der Rückspeisediode (32) mit den Polen der Spannungsquelle (U1) des Einschaltkreises (12) verbunden ist, **dadurch gekennzeichnet**, daß als Induktivität (L1) eine sättigbare Drossel (L4) vorgesehen ist und daß der Ausschaltkreis (14) eine Spannungsquelle (U2) mit paralleler Speicherkapazität (C2) und mit serieller Reihenschaltung eines Schalters (S2) und einer Induktivität (L2) aufweist, wobei der Ausschaltkreis (14) mit den Anschlüssen (4,6) des Steuerkreises des abschaltbaren Thyristors (2) verknüpft ist und mittels einer Entkopplungsdiode (34) vom Einschaltkreis (12) entkoppelt ist. (FIG 5)

4. Ansteuerschaltung nach einem der Ansprüche 1 bis 3, **dadurch gekennzeichnet**, daß das Ausgangssignal (i_{E1},i_{E2},i_{G}) der Stromquelle (16,18) des Einschaltkreises (12) regelbar ist.

5. Ansteuerschaltung nach einem der Ansprüche 1 bis 3, **dadurch gekennzeichnet**, daß die Energierückspeisung aus der Stromquelle (16,18) des Einschaltkreises (12) vom Wert der Spannung an der Speicherkapazität (C1) abhängig ist.

6. Ansteuerschaltung nach einem der Ansprüche 1 und 2, **dadurch gekennzeichnet**, daß der Wert der zweiten Induktivität (L3) sehr viel größer ist als der Wert der ersten Induktivität (L1).

## Claims

1. A drive circuit for a GTO thyristor (2) consisting of a turn-on circuit (12) and a turn-off circuit (14), wherein the turn-on circuit (12) comprises a voltage source (U1) with a parallel storage capacitor (C1) and a parallel series arrangement of a switch (S1) and a feedback diode (32), and a current source (16), wherein the current source (16) has the form of an inductance (L1) whose terminals (22, 24) on the one hand are connected by means of a switch (S3) and a freewheeling diode (20) to a positive pole of the voltage source (U1) of the turn-on circuit (12) and on the other hand are connected to a terminal (6) of the control circuit and by means of a switch (S4) to a negative pole of the voltage source (U1) of the turn-on circuit (12) of the GTO thyristor (2), and wherein the control terminal (4) of the turn-off thyristor (2) is connected by means of the switch (S1) and the feedback diode (32) to the poles of the voltage source (U1) of the turn-on circuit (12), characterised in that a second inductance (L3) is provided as second current source (18), the first terminal (28) of which is connected to the switch (S3) of the turn-on circuit (12) and the second terminal (30) of which is connected on the one hand by means of a freewheeling diode (26) and on the other hand by means of a switch (S5) to the poles of the voltage source (U1) of the turn-on circuit (12), and that the turn-off circuit (14) comprises a voltage source (U2) with a parallel storage capacitor (C2) and with a serial series arrangement of a switch (S2) and an inductance (L2), where the turn-off circuit (14) is connected to the terminals (4, 6) of the control circuit of the GTO thyristor (2) and is decoupled from the turn-on circuit (12) by means of a decoupling diode (34) (Fig. 3).

2. A drive circuit for a GTO thyristor (2) consisting of a turn-on circuit (12) and a turn-off circuit (14), wherein the turn-on circuit (12) comprises a voltage source (U1) with a parallel storage capacitor (C1) and a parallel series arrangement of a switch (S1) and a feedback diode (32), and a current source (16), wherein the current source (16) is formed by an inductance (L1) whose terminals (22, 24) on the one hand are connected by means of a switch (S3) and a freewheeling diode (20) to a positive pole of the voltage source (U1) of the turn-on circuit (12) and on the other hand are connected to a terminal (6) of the control circuit and by means of a switch (S4) to a negative pole of the voltage source (U1) of the turn-on circuit (12) of the turn-off thyristor (2) and wherein the control terminal (4) of the GTO thyristor (2) is connected by means of the switch (S1) and the feedback diode (32) to the poles of the voltage source (U1) of the turn-on circuit (12),
characterised in that a second inductance (L3) is provided as second current source (18), which second inductance (L3) is electrically connected in series with the first inductance (L1) in such manner that one connection terminal (36) of the two inductances (L1, L3) on the one hand is connected to the freewheeling diode (20) and on the other hand is connected to the switch (S4) of the turn-on circuit (12) and where a second terminal (30) of the second inductance (L3) is connected on the one hand by means of a freewheeling diode (26) and on the other hand by means of a switch (S5) to the poles of the voltage source (U1) of the turn-on circuit (12), and that the turn-off circuit (14) comprises a voltage source (U2) with a parallel storage capacitor (C2) and with a serial series arrangement of a switch (S2) and an inductance (L2), where the turn-off circuit (14) is connected to the terminals (4, 6) of the control circuit of the GTO thyristor (2) and is decoupled from the turn-on circuit (12) by means of a decoupling diode (34) (Fig. 4).

3. A drive circuit for a GTO thyristor (2) consisting of a turn-on circuit (12) and a turn-off circuit (14), wherein the turn-on circuit (12) comprises a voltage source (U1) with a parallel storage capacitor (C1) and a parallel series arrangement of a switch (S1) and a feedback diode (32), and a current source (16), wherein the current source (16) is formed by an inductance (L4) whose terminals (22, 24) on the one hand are connected by means of a switch (S3) and a freewheeling diode (20) to a positive pole of the voltage source (U1) of the turn-on circuit (12) and on the other hand are connected to a terminal (6) of the control circuit and by means of a switch (S4) to a negative pole of the voltage source (U1) of the turn-on circuit (12) of the GTO thyristor (2) and wherein the control terminal (4) of the GTO thyristor (2) is connected by means of the switch (S1) and the feedback diode (32) to the poles of the voltage source (U1) of the turn-on circuit (12),
characterised in that a saturable reactor (L4) is provided as inductance (L1) and that the turn-off circuit (14) comprises a voltage source (U2) with a parallel storage capacitor (C2) and a serial series arrangement of a switch (S2) and an inductance (L2), where the turn-off circuit (14) is connected to the terminals (4, 6) of the control circuit of the GTO thyristor (2) and is decoupled from the turn-on circuit (12) by means of a decoupling diode (34) (Fig. 5).

4. A drive circuit according to one of Claims 1 to 3, characterised in that the output signal (i_{E1}, i_{E2}, i_{G}) of the current source (16, 18) of the turn-on circuit (12) can be regulated.

5. A drive circuit according to one of Claims 1 to 3, characterised in that the power feedback from the current source (16, 18) of the turn-on circuit (12) is a function of the value of the voltage across the storage capacitor (C1).

6. A drive circuit according to one of Claims 1 and 2, characterised in that the value of the second inductance (L3) greatly exceeds the value of the first inductance (L1).

## Revendications

1. Circuit de commande pour un thyristor interruptible (2), constitué d'un circuit de connexion (12) et d'un circuit de déconnexion (14), le circuit de connexion (12) comportant une source de tension (U1), avec un condensateur de stockage (C1) branché en parallèle et avec un circuit série composé d'un interrupteur (S1) et d'une diode de réalimentation (32) et branché en parallèle, et une source de courant (16), une inductance (Ll) étant prévue comme source de courant (16), inductance (L1) dont les bornes (22, 24) sont reliées d'une part au moyen d'un interrupteur (S3) et d'une diode de roue libre (20) à un pôle positif de la source de tension (U1) du circuit de connexion (12) et d'autre part à une borne (6) du circuit de commande et au moyen d'un interrupteur (S4) à un pôle négatif de la source de tension (Ul) du circuit de connexion (12) du thyristor interruptible (2), et la borne de commande (4) du thyristor interruptible (2) étant reliée au moyen de l'interrupteur (S1) et au moyen de la diode de réalimentation (32) aux pôles de la source de tension (U1) du circuit de connexion (12),
caractérisé par le fait qu'il est prévu comme deuxième source de courant (18) une deuxième inductance (L3) dont la première borne (28) est reliée à l'interrupteur (S3) du circuit de connexion (12) et dont la deuxième borne (30) est reliée d'une part au moyen d'une diode de roue libre (26) et d'autre part au moyen d'un interrupteur (S5) aux pôles de la source de tension (Ul) du circuit de connexion (12) et que le circuit de déconnexion (14) comporte une source de tension (U2) avec un condensateur de stockage (C2) branché en parallèle et avec un circuit série composé d'un interrupteur (S2) et d'une inductance (L2) et branché en série, le circuit de déconnexion (14) étant relié aux bornes (4, 6) du circuit de commande du thyristor interruptible (2) et étant découplé du circuit de connexion (12) au moyen d'une diode de découplage (34). (figure 3)

2. Circuit de commande pour un thyristor interruptible (2), constitué d'un circuit de connexion (12) et d'un circuit de déconnexion (14), le circuit de connexion (12) comportant une source de tension (U1), avec un condensateur de stockage (Cl) branché en parallèle et avec un circuit série composé d'un interrupteur (S1) et d'une diode de réalimentation (32) et branché en parallèle, et une source de courant (16), une inductance (L1) étant prévue comme source de courant (16), inductance (L1) dont les bornes (22, 24) sont reliées d'une part au moyen d'un interrupteur (S3) et d'une diode de roue libre (20) à un pôle positif de la source de tension (Ul) du circuit de connexion (12) et d'autre part à une borne (6) du circuit de commande et au moyen d'un interrupteur (S4) à un pôle négatif de la source de tension (Ul) du circuit de connexion (12) du thyristor interruptible (2), et la borne de commande (4) du thyristor interruptible (2) étant reliée au moyen de l'interrupteur (S1) et au moyen de la diode de réalimentation (32) aux pôles de la source de tension (U1) du circuit de connexion (12),
caractérisé par le fait qu'il est prévu comme deuxième source de courant (18) une deuxième inductance (L3) qui est branchée électriquement en série avec la première inductance (Ll) de telle sorte qu'une borne de jonction (36) des deux inductances (L1, L3) est reliée d'une part à la diode de roue libre (20) et d'autre part à l'interrupteur (S4) du circuit de connexion (12), une deuxième borne (30) de la deuxième inductance (L3) étant reliée d'une part au moyen d'une diode de roue libre (26) et d'autre part au moyen d'un interrupteur (S5) aux pôles de la source de tension (Ul) du circuit de connexion (12), et que le circuit de déconnexion (14) comporte une source de tension (U2) avec un condensateur de stockage (C2) branché en parallèle et avec un circuit série composé d'un interrupteur (S2) et d'une inductance (L2) et branché en série, le circuit de déconnexion (14) étant relié aux bornes (4, 6) du circuit de commande du thyristor interruptible (2) et étant découplé du circuit de connexion (12) au moyen d'une diode de découplage (34) . (figure 4)

3. Circuit de commande pour un thyristor interruptible (2), constitué d'un circuit de connexion (12) et d'un circuit de déconnexion (14), le circuit de connexion (12) comportant une source de tension (U1), avec un condensateur de stockage (C1) branché en parallèle et avec un circuit série composé d'un interrupteur (S1) et d'une diode de réalimentation (32) et branché en parallèle, et une source de courant (16), une inductance (L4) étant prévue comme source de courant (16), inductance (L4) dont les bornes (22, 24) sont reliées d'une part au moyen d'un interrupteur (S3) et d'une diode de roue libre (20) à un pôle positif de la source de tension (U1) du circuit de connexion (12) et d'autre part à une borne (6) du circuit de commande et au moyen d'un interrupteur (S4) à un pôle négatif de la source de tension (U1) du circuit de connexion (12) du thyristor interruptible (2), et la borne de commande (4) du thyristor interruptible (2) étant reliée au moyen de l'interrupteur (S1) et au moyen de la diode de réalimentation (32) aux pôles de la source de tension (U1) du circuit de connexion (12),
caractérisé par le fait qu'il est prévu comme inductance (L4) une bobine saturable (L4) et que le circuit de déconnexion (14) comporte une source de tension (U2) avec un condensateur de stockage (C2) branché en parallèle et avec un circuit série composé d'un interrupteur (S2) et d'une inductance (L2) et branché en série, le circuit de déconnexion (14) étant relié aux bornes (4, 6) du circuit de commande du thyristor interruptible (2) et étant découplé du circuit de connexion (12) au moyen d'une diode de découplage (34). (figure 5)

4. Circuit de commande selon l'une des revendications 1 à 3, caractérisé par le fait que le signal de sortie (i_{E1}, i_{E2}, i_{G}) de la source de courant (16, 18) du circuit de connexion (12) est réglable.

5. Circuit de commande selon l'une des revendications 1 à 3, caractérisé par le fait que la réalimentation de l'énergie à partir de la source de courant (16, 18) du circuit de connexion (12) dépend de la valeur de la tension au condensateur de stockage (C1).

6. Circuit de commande selon l'une des revendications 1 et 2, caractérisé par le fait que la valeur de la deuxième inductance (L3) est bien plus grande que la valeur de la première inductance (L1).
